# EUROPÄISCHE PATENTSCHRIFT

(11) **EP 1 503 307 B1**
(45) Veröffentlichungstag und Bekanntmachung des Hinweises auf die Patenterteilung: **03.04.2019**
(21) Anmeldenummer: 03016640.9
(22) Anmeldetag: 30.07.2003
(51) Int. Cl.: G06F 17/50

(54) **Vorrichtung zur Emulation von Entwürfen für integrierte Schaltkreise**
Emulation device for integrated circuit design
Appareil pour l'émulation de conceptions des circuits intégrés

(43) Veröffentlichungstag der Anmeldung: 02.02.2005
(60) Teilanmeldung: 18168102.4
(73) Patentinhaber: Synopsys, Inc., Mountain View, CA 94043 (US)
(72) Erfinder: Mauersberger, Heiko, 99099 Erfurt (DE)
(74) Vertreter: Schlimme, Wolfram

(56) Entgegenhaltungen:
- US-B1- 6 263 484
- KHALID M: "Routing Architecture and Layout Synthesis for Multi-FPGA Systems" PHD THESIS, [Online] - 1999 Seiten 1-132, XP002260806 University of Toronto, Dept. of ECE Gefunden im Internet: <URL:http://www.eecg.toronto.edu/~jayar/pu bs/theses/Khalid/MohammedKhalid.pdf> [gefunden am 2003-11-07]
- HAUCK S: "THE ROLES OF FPGA'S IN REPROGRAMMABLE SYSTEMS" PROCEEDINGS OF THE IEEE, IEEE. NEW YORK, US, Bd. 86, Nr. 4, 1. April 1998 (1998-04-01), Seiten 613-638, XP000778371 ISSN: 0018-9219
- CARRERA J M ET AL: "Architecture of a FPGA-based coprocessor: the PAR-1" FPGAS FOR CUSTOM COMPUTING MACHINES, 1995. PROCEEDINGS. IEEE SYMPOSIUM ON NAPA VALLEY, CA, USA 19-21 APRIL 1995, LOS ALAMITOS, CA, USA,IEEE COMPUT. SOC, US, 19. April 1995 (1995-04-19), Seiten 20-29, XP010151150 ISBN: 0-8186-7086-X

## Beschreibung

Die Erfindung betrifft eine Vorrichtung zur Emulation von Entwürfen für integrierte Schaltkreise gemäß dem Oberbegriff des Patentanspruchs 1.

Eine gängige Methode zur Verifikation von Entwürfen für integrierte Schaltkreise, sogenannten Chipdesigns, ist deren Abbildung mit einer programmierbaren Hardware. Eine solche programmierbare Hardware ist häufig aus programmierbaren Logikschaltkreisen, sogenannten FPGA-Schaltkreisen (FPGA: field programmable gate array) aufgebaut. Den Vorgang der Verifikation auf einer solchen Hardware bezeichnet man als "Emulation" oder "Rapid Prototyping".

Da es aufgrund der Größe und Komplexität eines Entwurfs nicht immer möglich ist, den gesamten Entwurf in nur einem einzigen programmierbaren Logikschaltkreis abzubilden, wird eine programmierbare Hardware verwendet, die aus mehreren programmierbaren Logikschaltkreisen besteht. Ein dabei auftretendes Problem ist die geeignete Verdrahtung der Logikschaltkreise untereinander. Werden lediglich zwei Logikschaltkreise miteinander verbunden, so läßt sich diese Verbindung einfach als Eins-zu-eins-Verdrahtung aufbauen. Sollen jedoch drei Logikschaltkreise miteinander verbunden werden, so können diese entweder in einer Sternstruktur, in einer Dreiecksstruktur oder in einer Mischform miteinander verschaltet werden. Dabei treten bereits eine Vielzahl von Leitungskreuzungen auf, die in optimaler Weise auf der die Logikschaltkreise aufnehmenden Leiterplatte untergebracht werden müssen. Je mehr programmierbare Logikschaltkreise verwendet werden müssen, um ein Chipdesign zu verifizieren, um so komplizierter werden die Strukturen. Werden diese Strukturen nun auf einer speziell für den Anwendungsfall erstellten Leiterplatte abgebildet, so ergeben sich im wesentlichen zwei Nachteile:
- die Struktur muß beim Schaltungsentwurf und beim Layout der Leiterplatte bereits feststehen. Da sich aber das zu verifizierende Chipdesign zu diesem Zeitpunkt zumeist noch in Entwicklung befindet, ist es äußerst schwierig, im voraus ein Layout der Leiterplatte zu erstellen. Weiterhin treten dann Probleme auf, wenn sich aufgrund von Änderungen in der Entwicklung die benötigte Struktur ändert, so daß dann die Leiterplatte umgebaut werden müßte;
- eine für einen speziellen Anwendungsfall hergestellte Leiterplatte kann in der Regel nicht für zukünftige Anwendungsfälle verwendet werden, da dort wieder andere Anforderungen an die Verbindungsstruktur bestehen.

Aus der EP 0 651 343 sind ein Verfahren zur Verwendung einer elektronisch wiederkonfigurierbaren Gatterfeldlogik und ein dadurch hergestelltes Gerät bekannt, bei welchem die Logik-Schaltkreise über eine Kreuzschienen-Schaltanordnung (Anordnung aus sogenannten crossbar chips) miteinander verbunden sind.

Diese Lösung mittels Kreuzschienenschaltern ist jedoch nicht sehr vorteilhaft, da Kreuzschienenschalter Spezialschaltkreise sind, die ein begrenztes Einsatzgebiet besitzen und deren Marktverfügbarkeit nicht immer garantiert ist. Darüber hinaus wird das entsprechende Gehäuse des Kreuschienenschalter-Chips und dessen Aufbau um so komplexer, je größer die Anzahl der zu schaltenden Leitungen wird. Dementsprechend ist auch das Leiterplattendesign für derartige Chips äußerst aufwendig. Durch die hohe Komplexität dieser Kreuzschienenschalter-Chips, in denen jedes Signal mit jedem Signal verbunden werden kann, werden nur verhältnismäßig lange Durchlaufzeiten der Signale erreicht. Dieses hat im vorliegenden Anwendungsfall unmittelbaren Einfluß auf die Verifikationsgeschwindigkeit und auf die Verifikationszeit, indem die Verifikationsgeschwindigkeit sinkt und die Verifikationszeit ansteigt. Ziel ist es jedoch bei der Emulation von Entwürfen für integrierte Schaltkreise, den Chipentwurf mit möglichst hoher Geschwindigkeit zu verifizieren und damit die Verifikationszeit zu minimieren.

Die Literaturstelle Khalid M: 'Routing Architecture and Layout Synthesis for Multi-FPGA Systems' PHD THESIS, (Online) - 1999 Seiten 1-132, XP002260806 University of Toronto, Dept. of ECE Gefunden im Internet:<URL:http://www.eecg.toronto.edu/ ∼jayar/pubs/theses/Khalid/MohammedKhalid.pdf> (gefunden am 2003-11-07) offenbart eine Vorrichtung zur Emulation von Entwürfen für integrierte Schaltkreise, bei welcher eine Mehrzahl von FPGA-Systemen über einen Kreuzschienenschalter (FPID) miteinander verbunden ist. Ein derartiger Aufbau mittels Kreuzschienenschaltern erfordert, daß alle zu schaltenden Leitungen der miteinander zu verbindenden FPGAs zum Kreuzschienenschalter geführt werden müssen. Dies ist bereits bei nur zwei FPGAs ein schwieriges Unterfangen.

Aus der Literaturstelle Hauck S: 'The Roles of FPGA's in Reprogrammable Systems' Proceedings of the IEEE, IEEE. New York, US, Bd. 86, Nr. 4, 1. April 1998 (1998-04-01), Seiten 613-638, XP000778371 ISSN: 0018-9219 ist eine Vorrichtung bekannt, bei der die Signalverschaltung mittels frei programmierbarer FPGAs erfolgt. Auch hier müssen die zu verschaltenden Leitungen zu einem zentralen Punkt (zum Schalt-FPGA) geführt werden. Diese Verschaltung bedeutet nicht nur eine höhere Laufzeit aufgrund der zusätzlichen Leitungen sondern zudem auch eine Laufzeiterhöhung aufgrund der innerhalb des FPGA zurückzulegenden Leitungswege.

Es ist daher die Aufgabe der vorliegenden Erfindung, eine Vorrichtung zur Emulation von Entwürfen für integrierte Schaltkreise gemäß dem Oberbegriff des Patentanspruchs 1 derart auszugestalten, daß bei hoher Flexibilität der Verbindungsstruktur eine hohe Verifikationsgeschwindigkeit ermöglicht wird und damit die Verifikationszeit minimiert werden kann.

Diese Aufgabe wird durch die im Patentanspruch 1 angegebenen Merkmale gelöst.

Bei der erfindungsgemäßen Ausgestaltung der Emulationsvorrichtung wird eine den programmierbaren Logikschaltkreisen, insbesondere den FPGAs, innewohnende Eigenschaft ausgenutzt, nämlich jene, daß die Signale aus dem Logikschaltkreis an beliebige Anschlußkontakte des Logikschaltkreises geroutet werden können. Bei herkömmlichen integrierten Schaltkreisen (zum Beispiel Prozessoren) sind die Anschlußkontakte inneren Strukturen des Schaltkreises hingegen fest zugeordnet. Beim Erfindungsgegenstand wird die flexible Eigenschaft der beliebigen Kontaktierung der Anschlußkontakte mit inneren Strukturen des Logikschaltkreises ausgenutzt, um in Verbindung mit den wahlweise miteinander verbindbaren BUS-Leitungen genau jene Kombinationsmöglichkeiten herzustellen, die für den Aufbau des Entwurfs des integrierten Schaltkreises erforderlich sind. Es müssen also nicht, wie im mit Kreuzschienen-Schaltkreisen arbeitenden Stand der Technik, alle grundsätzlich möglichen Kombinationsmöglichkeiten vorgesehen werden.

Vorzugsweise ist eine Mehrzahl von Kanälen einer BUS-Leitung mit einer Mehrzahl von Kanälen einer anderen BUS-Leitung wahlweise elektrisch verbindbar, wobei jeder Kanal der einen BUS-Leitung mit dem zugeordneten Kanal der anderen BUS-Leitung elektrisch verbindbar ist, wobei die einzelnen Kanäle unabhängig voneinander verbindbar sind. Durch diese Ausgestaltung wird die Flexibilität erhöht.

Vorzugsweise sind zwischen zumindest einem Teil der programmierbaren Logikschaltkreise Verbindungs-BUS-Leitungen zur direkten Verbindung der entsprechenden Logikschaltkreise miteinander vorgesehen. Geht man von einem typischen Chipdesign aus, welches auf mehrere Logikschaltkreise (zum Beispiel FPGAs) verteilt wird, so ist die Wahrscheinlichkeit hoch, daß benachbarte Logikschaltkreise mehr Verbindungsleitungen untereinander benötigen, als Logikschaltkreise, die weiter voneinander entfernt sind. Für diese Verbindungsleitungen der benachbarten Logikschaltkreise sind Verbindungs-BUS-Leitungen zur direkten Verbindung vorgesehen. Hierdurch wird die Anzahl der benötigten Schalter reduziert und die Signallaufzeiten werden aufgrund der kurzen direkten Verbindungswege spürbar reduziert.

In einer bevorzugten Weiterbildung sind mehrere Aufnahmeeinrichtungen über Verbindungseinrichtungen miteinander verbindbar, wobei die Verbindungseinrichtungen schaltbare BUS-Leitungen aufweisen. Hierdurch wird es möglich, eine modular aufgebaute Vorrichtung zu schaffen, die durch Verbindung mehrerer Aufnahmeeinrichtungen, die im wesentlichen identisch aufgebaut sein können, realisiert wird.

Dabei sind vorzugsweise Haupt-Verbindungseinrichtungen vorgesehen, die jeweils zwei Aufnahmeeinrichtungen miteinander verbinden, wobei die Haupt-Verbindungseinrichtung BUS-Leitungen aufweisen, die jeweils einander zugeordnete BUS-Leitungen der beiden Aufnahmeeinrichtungen miteinander verbinden und wobei die BUS-Leitungen einer Haupt-Verbindungseinrichtung derart wahlweise miteinander elektrisch verbindbar sind, daß zumindest ein Kanal einer BUS-Leitung mit einem Kanal von zumindest einer anderen BUS-Leitung elektrisch verbindbar ist. Mit derartigen Haupt-Verbindungseinrichtungen können auf einfache Weise jeweils zwei Aufnahmeeinrichtungen zu einem Aufnahmeeinrichtungspaar miteinander verbunden werden.

Weiter vorteilhaft ist es, wenn Gruppen-Verbindungseinrichtungen vorgesehen sind, die jeweils zwei aus zwei mit einer Haupt-Verbindungseinrichtung verbundenen Aufnahmeeinrichtungen bestehende Aufnahmeeinrichtungspaare miteinander verbinden und wobei eine Gruppen-Verbindungseinrichtung BUS-Leitungen aufweist, die mit den BUS-Leitungen der jeweiligen Aufnahmeeinrichtungspaare verbunden sind und wobei die BUS-Leitungen der Gruppen-Verbindungseinrichtungen jeweils derart schaltbar sind, daß jedem Kanal einer jeden BUS-Leitung der Gruppen-Verbindungseinrichtung ein Schalter zugeordnet ist und daß die jeweiligen Schalter unabhängig voneinander ein- und ausschaltbar sind. Das Vorsehen dieser Gruppen-Verbindungseinrichtungen ermöglicht es, Paare von Aufnahmeeinrichtungen, die jeweils mittels einer Haupt-Verbindungseinrichtung miteinander verbunden sind, nahezu beliebig aneinander zu reihen.

In einer bevorzugten Realisierung der erfindungsgemäßen Vorrichtung weisen die Aufnahmeeinrichtungen, die Haupt-Verbindungseinrichtungen und die Gruppen-Verbindungseinrichtungen Leiterplatten auf, die an ihrer Oberseite und an ihrer Unterseite jeweils mit einer Steckverbinderanordnung versehen sind, die aus mehreren Steckverbindern besteht, welche in derselben Position auf der jeweiligen Leiterplatte angeordnet sind und wobei die nach außen führenden BUS-Leitungen der jeweiligen Leiterplatte sowohl mit oberen als auch mit entsprechenden unteren Steckverbindern der jeweiligen Steckverbinderanordnung in gleicher Weise elektrisch verbunden sind. Diese Ausgestaltung gestattet einen modularen Aufbau der erfindungsgemäßen Vorrichtung, da Aufnahmeeinrichtungen, Haupt-Verbindungseinrichtungen und Gruppen-Verbindungseinrichtungen einfach übereinander angeordnet und zur Kontaktierung zusammengesteckt werden können.

Eine bevorzugte Ausgestaltung dieses modularen Aufbaus zeichnet sich dadurch aus, daß die Leiterplatten übereinander angeordnet und mittels der Steckverbinderanordnungen mechanisch und elektrisch miteinander verbunden sind, wobei jeweils zwei Leiterplatten der Aufnahmeeinrichtungen mittels einer zwischen diesen angeordneten Leiterplatte einer Haupt-Verbindungseinrichtung sandwichartig zu einem Aufnahmeeinrichtungspaar verbunden sind und wobei die Aufnahmeeinrichtungspaare miteinander mittels der Leiterplatten der Gruppen-Verbindungseinrichtungen verbunden sind. Durch diese sandwichartige und modulare Anordnung der Aufnahmeeinrichtungen, Haupt-Verbindungseinrichtungen und Gruppen-Verbindungseinrichtungen entsteht ein kompakter Block als Aufbau einer erfindungsgemäßen Vorrichtung mit extrem kurzen Signalwegen und entsprechend kurzen Signallaufzeiten, wodurch eine hohe Verifikationsgeschwindigkeit erzielt werden kann.

Vorzugsweise ist zwischen einigen der Steckverbinder der jeweiligen Steckverbinderanordnungen ein Abstand vorgesehen, der das Durchströmen von Kühlluft zwischen den Steckverbindern durch das Leiterplatten-Sandwich ermöglicht. Die Kühlluft kann in dieser Anordnung sehr wirksam, beispielsweise nach dem Querstromprinzip, die Leiterplatten umfließen und die dort entstehende Wärme abführen.

Zur Durchführung der flexiblen Verschaltung der Verbindungsstruktur einer Vorrichtung zur Emulation von Entwürfen für integrierte Schaltkreise gemäß der Erfindung wird besonders bevorzugt ein Computerprogramm eingesetzt, welches die folgenden Programmschritte ausführt:
- Überprüfen, ob in dem zu emulierenden Entwurf eines integrierten Schaltkreises Elemente mit einer Plazierungsvorgabe vorgesehen sind;
- falls derartige Elemente vorgesehen sind, Zuordnen eines Einbauplatzes der Aufnahmeeinrichtung für das jeweilige Element;
- Zuordnen eines jeweiligen Einbauplatzes für ein jeweiliges Element ohne Plazierungsvorgabe;
- Überprüfen, ob zwischen den Elementen untereinander und/oder mit externen Erweiterungselementen Sinale über vorgegebene Anschlußkontakte auszutauschen sind;
- falls dies der Fall ist, Zuordnen der jeweiligen Anschlußkontakte zueinander über entsprechende Kanäle der BUS-Leitungen;
- Routen der verbleibenden auszutauschenden Signale;
- Berechnen der internen und externen Belegung der Anschlußkontakte der Logikschaltkreise;
- Herstellen der internen Verbindungen zwischen dem zu emulierenden integrierten Schaltkreisentwurf und den zugeordneten Anschlußkontakten eines jeden programmierbaren Logikschaltkreises und
- Herstellen der externen Verbindungen zwischen den Anschlußkontakten der programmierbaren Logikschaltkreise und den zugeordneten Kanälen der BUS-Leitungen.

Ein derartiges Computerprogramm beschleunigt den Vorgang der Schaltungsauflösung und der Verbindung der einzelnen Logikschaltkreise untereinander und steuert die einzelnen Schalter unmittelbar an.

Die Erfindung wird nachfolgend anhand eines Beispiels unter Bezugnahme auf die Zeichnung näher erläutert; in dieser zeigt:
- **Fig. 1.**: eine schematische Darstellung einer ersten Ausführungsform einer erfindungsgemäßen Vorrichtung;
- **Fig. 2.**: eine vergrößerte schematische Darstellung einer schaltbaren BUS-Leitung gemäß der vorliegenden Erfindung;
- **Fig. 3.**: eine schematische Darstellung einer weiteren Ausführungsform der vorliegenden Erfindung mit zwei ein Aufnahmeeinrichtungspaar bildenden Aufnahmeeinrichtungen;
- **Fig. 4.**: eine schematische Darstellung noch einer weiteren Ausführungsform der vorliegenden Erfindung mit drei Aufnahmeeinrichtungspaaren;
- **Fig. 5.**: einen schematischen Grundriß der Steckverbinderanordnung, wie sie auf einer Aufnahmeeinrichtung, einer Haupt-Verbindungseinrichtung und einer Gruppen-Verbindungseinrichtung vorgesehen ist;
- **Fig. 6.**: eine Seitenansicht eines Leiterplatten-Sandwiches einer erfindungsgemäßen Vorrichtung; und
- **Fig. 7.**: ein Flußdiagramm eines Computerprogramms zur flexiblen Verschaltung der Verbindungsstruktur einer erfindungsgemäßen Vorrichtung.

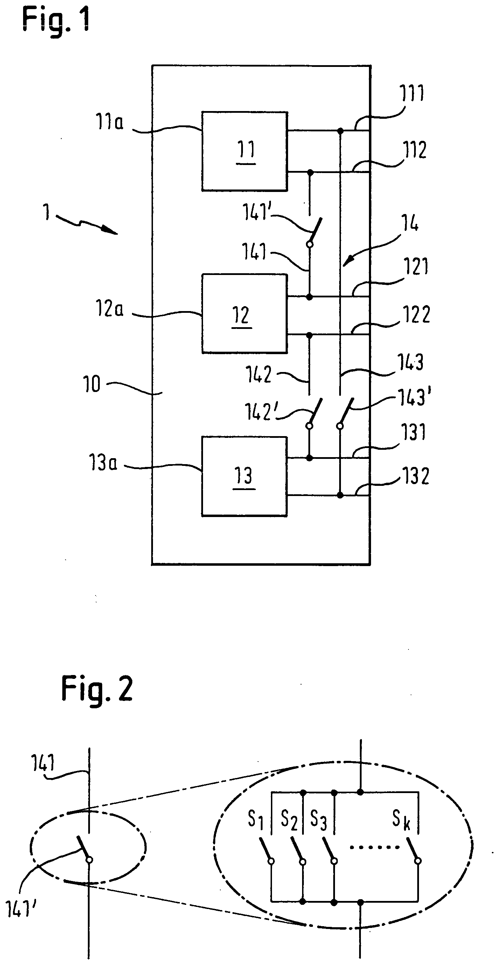

In Fig. 1 ist eine Aufnahmeeinrichtung 1 gezeigt, die eine Leiterplatte 10 aufweist, auf der drei Einbauplätze 11a, 12a, 13a für programmierbare Logikschaltkreise 11, 12, 13 und eine in der Fig. 1 nur schematisch dargestellte elektrische Verbindungsstruktur 14 vorgesehen sind.

Jeder der Einbauplätze 11a, 12a, 13a für die entsprechenden programmierbaren Logikschaltkreise 11, 12, 13 ist mit zwei BUS-Leitungen 111, 112; 121, 122; 131, 132 verbunden, wobei jede der BUS-Leitungen mit einer Mehrzahl von (nicht gezeigten) Anschlußkontakten des jeweiligen Einbauplatzes 11a, 12a, 13a verbunden ist. Das Vorsehen von jeweils zwei BUS-Leitungen pro Einbauplatz ist lediglich beispielhaft gezeigt; es können pro Einbauplatz auch nur eine BUS-Leitung oder mehr als zwei BUS-Leitungen vorgesehen sein.

Die BUS-Leitungen 111, 112; 121, 122; 131, 132 sind durch BUS-Verbindungsleitungen 141, 142, 143 miteinander verbunden, wobei in jeder BUS-Verbindungsleitung eine weiter unten unter Bezugnahme auf Fig. 2 näher erläuterte BUS-Schaltvorrichtung 141'; 142'; 143' vorgesehen ist. Im einzelnen verbindet die schaltbare BUS-Verbindungsleitung 141 die zweite BUS-Leitung 112 des ersten Einbauplatzes 11a mit der ersten BUS-Leitung 121 des zweiten Einbauplatzes 12a. Die BUS-Verbindungsleitung 142 verbindet die zweite BUS-Leitung 122 des zweiten Einbauplatzes 12a mit der ersten BUS-Leitung 131 des dritten Einbauplatzes 13a. Die BUS-Verbindungsleitung 143 verbindet die zweite BUS-Leitung 132 des dritten Einbauplatzes 13a mit der ersten BUS-Leitung 111 des ersten Einbauplatzes 11a.

In Fig. 2 ist die BUS-Schaltvorrichtung 141' der ersten BUS-Verbindungsleitung 141 schematisch in einer Vergrößerung dargestellt. Man kann erkennen, daß die BUS-Schaltvorrichtung 141' aus einer Vielzahl von Schaltern S₁ bis Sₖ besteht, die jeweils einen der Kanäle 1 bis k der BUS-Verbindungsleitung 141 schalten. Die Schalter S₁ bis Sₖ können dabei unabhängig voneinander ein- und ausgeschaltet werden. Die BUS-Schalteranordnung 141' kann so ausgebildet sein, daß sie alle Kanäle der BUS-Verbindungsleitung 141 oder nur einen Teil davon schaltet. Die anderen BUS-Schaltvorrichtungen 142', 143' sind auf dieselbe Weise ausgebildet wie die erste BUS-Schaltvorrichtungen 141'.

Durch die Schaltbarkeit der einzelnen Kanäle der BUS-Verbindungsleitungen 141, 142, 143 und die freie Belegbarkeit der Anschlußkontakte eines jeden programmierbaren Logikschaltkreises 11, 12, 13 läßt sich jede gewünschte Verbindung in einer Ringstruktur zwischen den Logikschaltkreisen 11, 12, 13 herstellen.

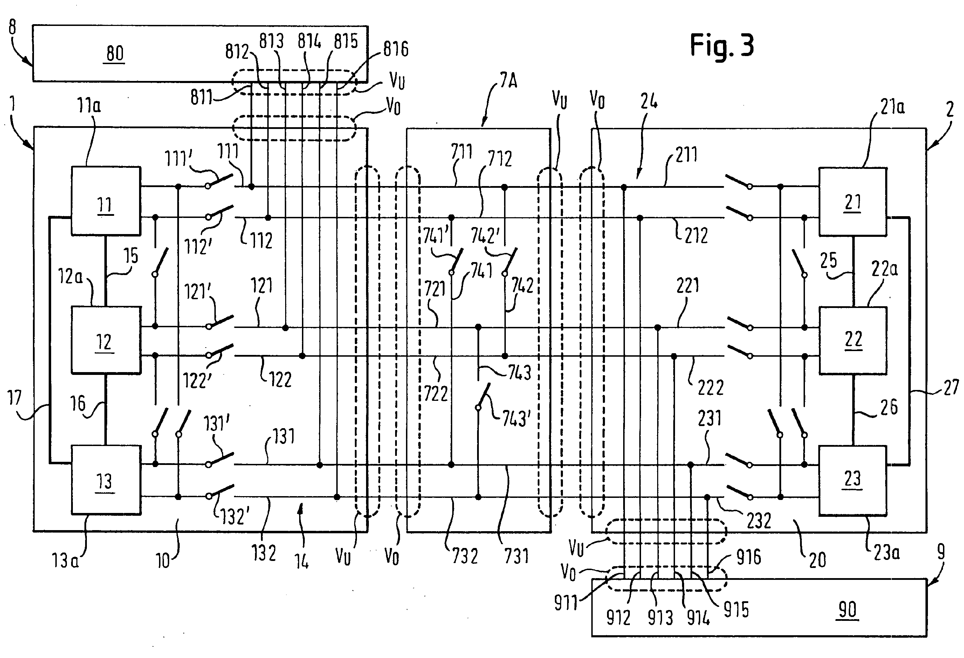

In Fig. 3 ist eine Paarung zweier Aufnahmeeinrichtungen 1, 2 dargestellt, die über eine Haupt-Verbindungseinrichtung 7A elektrisch miteinander verbunden sind. In der Figur sind die Aufnahmeeinrichtungen 1, 2 sowie die Haupt-Verbindungseinrichtung 7A zum besseren Verständnis der elektrischen Verbindungen in der Ebene nebeneinander dargestellt. In der Praxis sind sie jedoch übereinander angeordnet, wie es weiter unten noch beschrieben wird. Die Aufnahmeeinrichtung 1 entspricht im wesentlichen der Aufnahmeeinrichtung 1 aus Fig. 1, enthält jedoch zusätzlich auf der Leiterplatte 10 direkte Verbindungs-BUS-Leitungen 15, 16, 17, wobei die Verbindungs-BUS-Leitung 15 einen Teil der Anschlußkontakte des ersten Einbauplatzes 11a mit einem Teil der Anschlußkontakte des zweiten Einbauplatzes 12a verbindet. Die zweite Verbindungs-BUS-Leitung 16 verbindet einen Teil der Anschlußkontakte des zweiten Einbauplatzes 12a mit einem Teil der Anschlußkontakte des dritten Einbauplatzes 13a und die dritte Verbindungs-BUS-Leitung 17 verbindet einen Teil der Anschlußkontakte des dritten Einbauplatzes 13a mit einem Teil der Anschlußkontakte des ersten Einbauplatzes 11a. Über diese direkten Verbindungs-BUS-Leitungen werden Signale geroutet, die zwischen den einzelnen programmierbaren Logikschaltkreisen 11, 12, 13 direkt ausgetauscht werden, ohne daß es dazu einer flexiblen Programmierung des ganzen Routings bedarf.

Die Leiterplatte 10 der ersten Aufnahmeeinrichtung 1 weist außerdem gegenüber der in Fig. 1 nur schematisch dargestellten Schaltung BUS-Schaltvorrichtungen 111', 112'; 121', 122'; 131', 132' auf, die jeweils in den zugeordneten BUS-Leitungen 111, 112; 121, 122; 131, 132 auf der vom zugehörigen Einbauplatz 11a; 12a; 13a abgewandten Seite der jeweiligen BUS-Verbindungsleitung 141; 142; 143 vorgesehen sind. Diese BUS-Schaltvorrichtungen 111', 112'; 121', 122'; 131', 132' sind genauso aufgebaut wie die in Fig. 2 dargestellte BUS-Schaltvorrichtung. Die BUS-Leitungen 111, 112, 121, 122, 131, 132 sind auf der von den Schaltvorrichtungen 111', 112'; 121', 122'; 131', 132' bezüglich des zugeordneten Einbauplatzes 11a; 12a; 13a abgewandten Seite mit auf der Oberseite der Leiterplatte 10 angeordneten, in Fig. 3 nur schematisch gezeigten, Steckverbindern einer oberen Steckverbinderanordnung V_{O} und mit an der Unterseite der Leiterplatte 10 angeordneten, in Fig. 3 ebenfalls nur schematisch dargestellten, Steckverbindern einer unteren Steckverbinderanordnung V_{U} elektrisch verbunden. Jedem Kanal einer BUS-Leitung sind dabei ein Kontakt der oberen Steckverbinderanordnung V_{O} und der diesem entsprechende Kontakt der unteren Steckverbinderanordnung V_{U} zugeordnet.

Die Aufnahmeeinrichtung 2 besteht im Beispiel der Fig. 3 aus einer Leiterplatte 20, die in dieser schematischen Schaltungsansicht spiegelverkehrt zur Leiterplatte 10 der Aufnahmeeinrichtung 1 dargestellt ist, in der praktischen Ausführung sind die Leiterplatten 10 und 20 jedoch im wesentlichen identisch aufgebaut. Die Aufnahmeeinrichtung 2 weist ebenfalls drei programmierbare Logikschaltkreise 21, 22, 23 auf, die über eine Verbindungsstruktur 24 miteinander in der gleichen Weise verbunden sind wie dies in der Aufnahmeeinrichtung 1 der Fall ist. Auch die direkten Verbindungs-BUS-Leitungen 25, 26, 27 sind analog vorgesehen. Die von den Einbauplätzen 21a, 22a, 23a der Leiterplatte 20 ausgehenden BUS-Leitungen 211, 212, 221, 222, 231, 232 entsprechen den BUS-Leitungen der Fig. 1 mit einem um 100 niedrigeren Bezugszeichen. Auch die entsprechenden BUS-Verbindungsleitungen sind wie in der Aufnahmeeinrichtung 1 vorgesehen und mit entsprechenden BUS-Schalteinrichtungen versehen. Die Aufnahmeeinrichtung 2 entspricht somit im Aufbau der Aufnahmeeinrichtung 1.

Die zwischen den Aufnahmeeinrichtungen 1 und 2 angeordnete Haupt-Verbindungseinrichtung 7A weist entsprechende BUS-Leitungen 711, 712; 721, 722; 731, 732 auf, die über jeweilige Steckverbinder einer oberen Steckverbinderanordnung V_{O} sowie einer unteren Steckverbinderanordnung V_{U} die jeweiligen BUS-Leitungen der Aufnahmeeinrichtungen 1 und 2 miteinander verbinden. Dabei verbindet die erste BUS-Leitung 711 die BUS-Leitung 111 der Aufnahmeeinrichtung 1 mit der BUS-Leitung 211 der Aufnahmeeinrichtung 2. Die zweite BUS-Leitung 712 verbindet die BUS-Leitung 112 der Aufnahmeeinrichtung 1 mit der BUS-Leitung 212 der Aufnahmeeinrichtung 2. Die dritte BUS-Leitung 721 verbindet die BUS-Leitung 121 der Aufnahmeeinrichtung 1 mit der BUS-Leitung 221 der Aufnahmeeinrichtung 2. Die vierte BUS-Leitung 722 verbindet die BUS-Leitung 122 der Aufnahmeeinrichtung 1 mit der BUS-Leitung 222 der Aufnahmeeinrichtung 2. Die fünfte BUS-Leitung 731 verbindet die BUS-Leitung 131 der Aufnahmeeinrichtung 1 mit der BUS-Leitung 231 der Aufnahmeeinrichtung 2. Die sechste BUS-Leitung 732 verbindet die BUS-Leitung 132 der Aufnahmeeinrichtung 1 mit der BUS-Leitung 232 der Aufnahmeeinrichtung 2.

Auch die Haupt-Verbindungseinrichtung 7A ist mit schaltbaren BUS-Verbindungsleitungen 741, 742, 743 versehen, wobei die BUS-Verbindungsleitung 741 die zweite BUS-Leitung 712 mit der fünften BUS-Leitung 731 verbindet. Die BUS-Verbindungsleitung 742 verbindet die erste BUS-Leitung 711 mit der vierten BUS-Leitung 722 und die BUS-Verbindungsleitung 743 verbindet die dritte BUS-Leitung 721 mit der sechsten BUS-Leitung 732.

Jede der BUS-Verbindungsleitungen 741, 742, 743 weist eine BUS-Schaltvorrichtung 741', 742', 743' auf, die jeweils entsprechend der in Fig. 2 gezeigten BUS-Schaltvorrichtung aufgebaut ist.

Die BUS-Schaltvorrichtungen in der Haupt-Verbindungseinrichtung 7A ermöglichen in Zusammenhang mit den BUS-Schaltvorrichtungen der Aufnahmeeinrichtungen 1 und 2 ein beliebiges Verschalten der an die einzelnen BUS-Kanäle angelegten Anschlußkontakte der jeweiligen Einbauplätze 11a, 12a, 13a, 21a, 22a, 23a für die programmierbaren Logikschaltkreise 11, 12, 13, 21, 22, 23 sowohl in einer Ringstruktur, als auch in einer Sternstruktur, als auch in einer gemischten Struktur.

Wird die Haupt-Verbindungseinrichtung 7A nur mit einer Aufnahmeeinrichtung 1; 2 verwendet, so wird zusätzlich zu der in Fig. 1 gezeigten Möglichkeit der Schaltung einer Ringstruktur auch die Schaltung einer Sternstruktur oder einer aus diesen beiden gemischten Hybridstruktur möglich.

Die Fig. 3 zeigt weiterhin eine Erweiterungseinrichtung 8, die über Steckverbinder einer unteren Steckverbinderanordnung V_{U} mit Steckverbindern der oberen Steckverbinderanordnung V_{O} der Leiterplatte 10 der Aufnahmeeinrichtung 1 verbunden ist, so daß die BUS-Leitungen 111, 112, 121, 122, 131, 132 der ersten Aufnahmeeinrichtung 1 mit jeweiligen BUS-Leitungen 811, 812, 813, 814, 815, 816 der Erweiterungseinrichtung 8 verbunden sind. Die Erweiterungseinrichtung 8 kann beispielsweise eine Leiterplatte 80 aufweisen, auf der elektronische Bausteine wie Prozessoren, Speicher oder andere integrierte Schaltkreise vorgesehen sind, die mit dem programmierbaren Logikschaltkreisen des zu emulierenden Entwurfs eines integrierten Schaltkreises zusammenwirken.

Die Aufnahmeeinrichtung 2, deren Steckverbinder der oberen Steckverbinderanordnung V_{O} mit den Steckverbindern der unteren Steckverbinderanordnung V_{U} der Leiterplatte 70 der Haupt-Verbindungseinrichtung 7A elektrisch verbunden sind, ist mit den Steckverbindern ihrer unteren Steckverbinderanordnung V_{U} mit einer schematisch dargestellten benachbarten Platine 90 elektrisch verbunden, die zu einer weiteren Erweiterungseinrichtung 9 oder auch zu einer nachfolgend beschriebenen Gruppen-Verbindungseinrichtung gehören kann. Die BUS-Leitungen 911, 912, 913, 914, 915, 916 der Leiterplatte 90 sind dabei in entsprechender Weise mit den BUS-Leitungen 211, 212, 221, 222, 231, 232 der zweiten Aufnahmeeinrichtung 2 elektrisch verbunden.

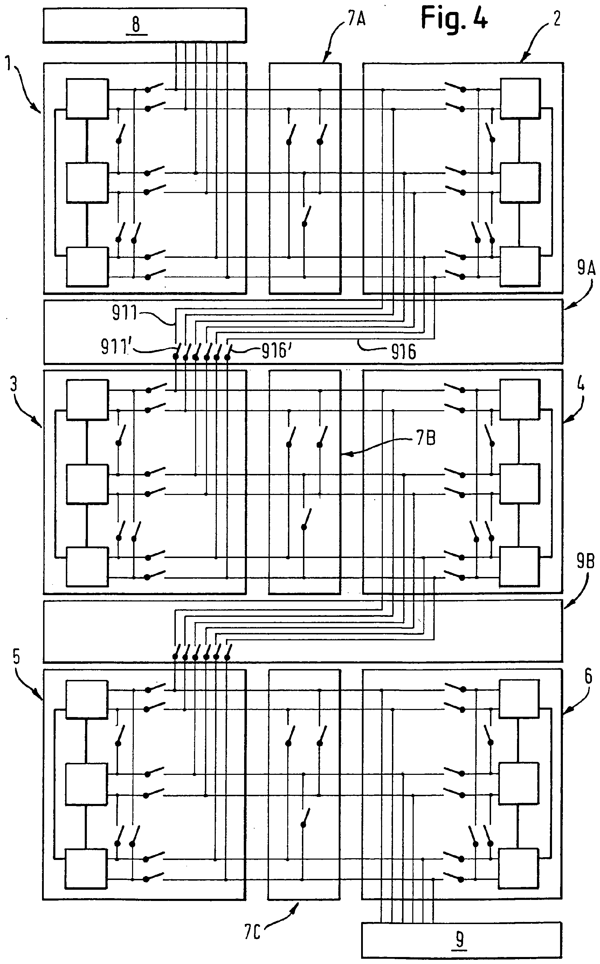

In Fig. 4 sind jeweils drei Aufnahmeeinrichtungspaare 1, 2; 3, 4; 5, 6 mittels Gruppen-Verbindungseinrichtungen 9A, 9B zu einem Block von sechs Aufnahmeeinrichtungen für insgesamt 18 programmierbare Logikschaltkreise zusammengeschlossen. Die Aufnahmeeinrichtungspaare 3, 4 und 5, 6 sind in der gleichen Weise aufgebaut wie das im Bezug auf Fig. 3 beschriebene Aufnahmeeinrichtungspaar 1, 3 und bestehen jeweils aus zwei Aufnahmeeinrichtungen 3, 4 und 5, 6, die jeweils über Haupt-Verbindungseinrichtungen 7B beziehungsweise 7C miteinander verbunden sind. In der Fig. 4 sind die Aufnahmeeinrichtungspaare sowie die Gruppen-Verbindungseinrichtungen 9A, 9B zum besseren Verständnis der elektrischen Verbindung in der Ebene untereinander dargestellt. In der Praxis sind sie jedoch flächig übereinander angeordnet, wie es weiter unten noch beschrieben wird.

Die Gruppen-Verbindungseinrichtungen 9A und 9B sind identisch aufgebaut und sind wie die Erweiterungsleiterplatte 9 in Fig. 3 an die benachbarte Aufnahmeeinrichtung 2, 4 beziehungsweise 4, 6 angeschlossen, wie dies in Bezug auf die Aufnahmeeinrichtung 2 im Zusammenhang mit der Fig. 3 beschrieben worden ist und in der Fig. 4 in Bezug auf die Aufnahmeeinrichtungen 4 und 6 dargestellt ist. Jede der Gruppen-Verbindungseinrichtungen 9A, 9B weist somit BUS-Leitungen 911, 912, 913, 914, 915 und 916 auf, die mit den entsprechenden BUS-Leitungen der benachbarten Aufnahmeeinrichtungen 2, 4 beziehungsweise 4, 6 in der bereits beschriebenen Weise mittels entsprechender Steckverbinder von oberen und unteren Steckverbinderanordnungen elektrisch verbunden sind. In jeder der BUS-Leitungen 911, 912, 913, 914, 915, 916 ist eine BUS-Schaltvorrichtung 911', bis 916' vorgesehen, die der im Zusammenhang mit der Fig. 2 beschriebenen Schaltvorrichtung entspricht.

Die in Fig. 4 dargestellte Verkoppelung der Aufnahmeeinrichtungen 1, 2, 3, 4, 5, 6 mittels der Haupt-Verbindungseinrichtungen 7A, 7B, 7C und der Gruppen-Verbindungseinrichtungen 9A und 9B ermöglicht es, in Verbindung mit der flexiblen Belegung der Anschlußkontakte eines jeden programmierbaren Logikschaltkreises, daß durch geeignete Wahl der jeweiligen Schaltereinstellungen eine beliebige Verschaltung der einzelnen Logik-Schaltkreise vorgenommen werden kann.

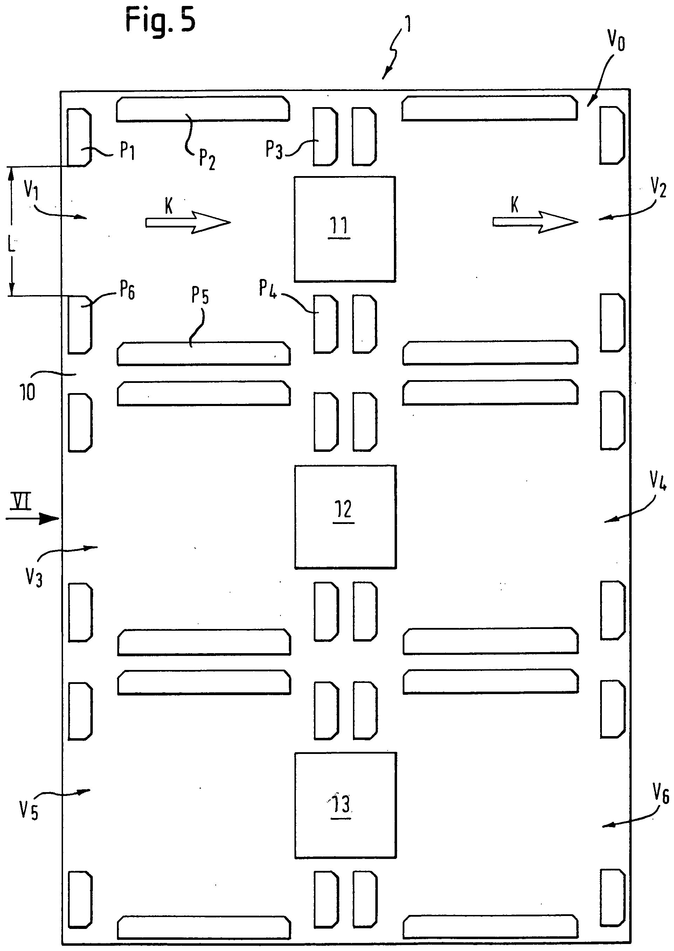

In Fig. 5 ist der schematische Grundriß einer Leiterplatte 10 der in Fig. 1 dargestellten Aufnahmeeinrichtung 1 gezeigt. Die einzelnen als Leiterbahnen ausgebildeten Kanäle der jeweiligen BUS-Leitungen sind nicht dargestellt, um die Figur nicht unübersichtlich erscheinen zu lassen. Bei dieser Draufsicht auf die Leiterplatte 10 sind die programmierbaren Logikschaltkreise 11, 12, 13 sowie die oberen Steckverbinderanordnungen V_{O} nur schematisch dargestellt. Die obere Steckverbinderanordnung V_{O} umfaßt eine Vielzahl von Steckverbindern, die in sechs Gruppen V₁, V₂, V₃, V₄, V₅, V₆ zu je sechs im wesentlichen quadratisch angeordneten Steckverbindern P₁, P₂, P₃, P₄, P₅, P₆ angeordnet sind. Jede der Steckverbindergruppen V₁, V₂, V₃, V₄, V₅, V₆ ist einer der BUS-Leitungen 111, 112, 121, 122, 131, 132 zugeordnet und jeder der BUS-Kanäle ist mit einem der Kontakte der Steckverbinder P₁, P₂, P₃, P₄, P₅, P₆ verbunden. Auf die gleiche Weise, wie dies vorstehend unter Bezugnahme auf die Steckverbindergruppe V₁ für die BUS-Leitung 111 beschrieben worden ist, sind auch die Steckverbinder-Gruppen V₂, V₃, V₄, V₅ und V₆ ausgebildet.

In Fig. 5 ist auch zu erkennen, daß zwischen den in Längsrichtung der Leiterplatte 10 angeordneten Steckverbindern P₁ und P₆ ein Abstand L freigehalten ist, durch den Kühlluft zu dem zwischen den Steckverbindern P₃ und P₄ angeordneten programmierbaren Logikschaltkreis 11 hin und an diesem seitlich und oben vorbei strömen und an der gegenüber gelegenen Seite durch eine entsprechende Öffnung L' von der Länge L wieder austreten kann. Der Verlauf der Kühlluft-Strömung ist durch Pfeile K schematisch dargestellt.

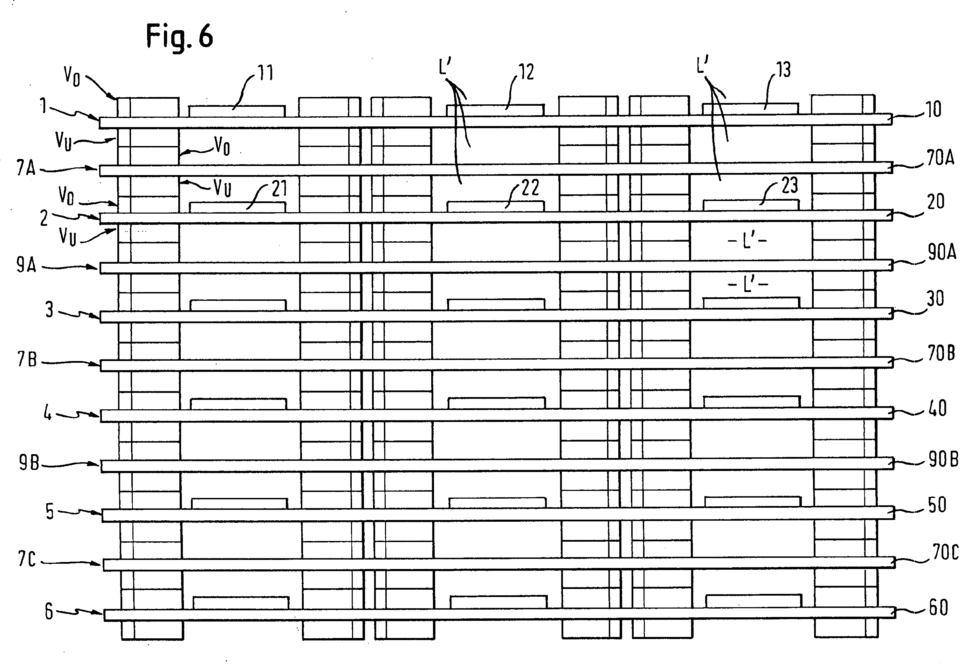

Die Fig. 6 zeigt eine Seitenansicht eines Stapels aus Leiterplatten von Aufnahmeeinrichtungen 1, 2, 3, 4, 5, 6 sowie Haupt-Verbindungseinrichtungen 7A, 7B, 7C und Gruppen-Verbindungseinrichtungen 9A, 9B in Richtung des Pfeils VI in Fig. 5. In dieser Darstellung ist zu sehen, daß die unteren Steckverbinderanordnungen V_{U} im Grundriß deckungsgleich mit den oberen Steckverbinderanordnungen V_{O} angeordnet sind, so daß sich die Leiterplatten 10, 70A, 20, 90A, 30, 70B, 40, 90B, 50, 70C, 60 wie in Fig. 6 gezeigt aufeinander stecken lassen. In Fig. 6 ist auch die durch den Abstand L und den Vertikalabstand zwischen zwei Leiterplatten definierte Kühllufteintrittsöffnung beziehungsweise Kühlluftaustrittsöffnung L' zu erkennen. Des weiteren ist zu erkennen, daß sowohl die oberste Leiterplatte 10 als auch die unterste Leiterplatte 60 mit freien oberen beziehungsweise unteren Steckverbinderanordnungen V_{O} beziehungsweise V_{U} versehen ist, in die noch weitere Einrichtungen, beispielsweise Erweiterungseinrichtungen, gesteckt werden können.

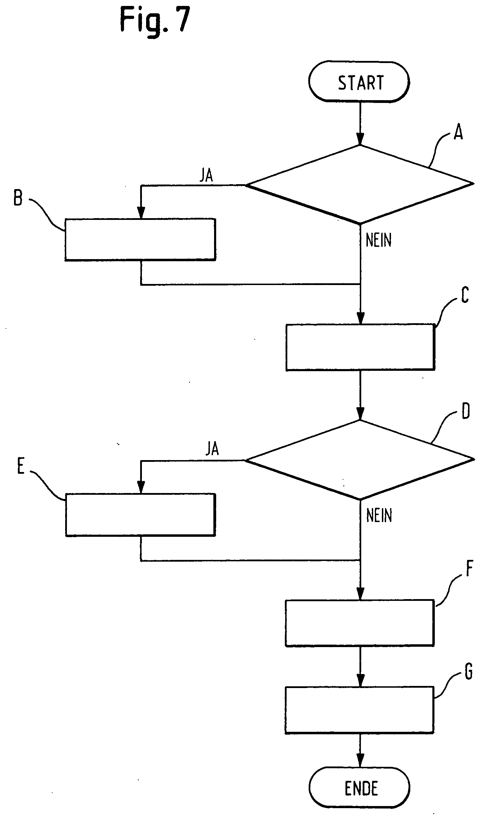

In Fig. 7 ist der Ablauf eines Computerprogramms zur flexiblen Verschaltung der Verbindungsstruktur einer erfindungsgemäßen Vorrichtung schematisch dargestellt.

Nach dem Start des Programms prüft das Computerprogramm in einem ersten Schritt A, ob es Elemente in dem zu emulierenden Entwurf eines integrierten Schaltkreises gibt, die eine Plazierungsvorgabe erfordern. Derartige Elemente sind beispielsweise programmierbare Logikschaltkreise oder Erweiterungsleiterplatten. Gibt es derartige Elemente, so werden diese Elemente in einem Schritt B vor allen anderen Elementen mit ihrer Plazierungsvorgabe plaziert. Danach werden im Schritt C jene Elemente plaziert, die keine Plazierungsvorgabe besitzen. Nachdem die Elemente alle plaziert worden sind, wird im Schritt D überprüft, ob es Signale gibt, die ein festes Pinmapping, das heißt eine feste Belegung von Anschlußkontakten, erfordern. Derartige Signale mit festem Pinmapping können beispielsweise die Verbindungen von den programmierbaren Logikschaltkreisen zu den Erweiterungselementen sein. Gibt es derartige Signale, so werden diese im Schritt E mit Vorrang geroutet. Danach werden im Schritt F alle restlichen Signale geroutet. Unter Routen versteht man dabei das Zuordnen von Leitungswegen in der gesamten BUS-Verbindungsstruktur. Sind alle Signale geroutet worden, so werden im Schritt G die sogenannten Pinmappings an den programmierbaren Logikschaltkreisen berechnet, das heißt, daß berechnet wird, welcher Kontakt von welcher BUS-Leitung, der an einem Einbauplatz anliegt, mit welchen Anschluß der internen Struktur des programmierbaren Logikschaltkreises zu verbinden ist.

Ist dies erfolgt, so werden die einzelnen Schalter der jeweiligen BUS-Schaltvorrichtungen geschaltet und die interne Belegung der Anschlußkontakte der jeweiligen programmierbaren Logik-Schaltkreise wird entsprechend dem berechneten Pinmapping eingerichtet.

Die Erfindung ist nicht auf das obige Ausführungsbeispiel beschränkt, das lediglich der allgemeinen Erläuterung des Kerngedankens der Erfindung dient.

Bezugszeichen in den Ansprüchen, der Beschreibung und den Zeichnungen dienen lediglich dem besseren Verständnis der Erfindung und sollen den Schutzumfang nicht einschränken.

## Patentansprüche

1. Vorrichtung zur Emulation von Entwürfen für integrierte Schaltkreise mit
zumindest einer Aufnahmeeinrichtung (1, 2, 3, 4, 5, 6) ausgebildet zur Aufnahme von einer Mehrzahl von programmierbaren Logikschaltkreisen (11, 12, 13; 21, 22, 23) mit Anschlusskontakten sowie
einer elektrischen Verbindungsstruktur (14; 24), die BUS-Leitungen (111, 112, 121, 122, 131, 132; 211, 212, 221, 222, 231, 232) aufweist, die jeweils eine Mehrzahl von Kanälen (1...k) umfassen,
wobei jeder programmierbare Logikschaltkreis (11, 12, 13; 21, 22, 23) der Mehrzahl von programmierbaren Logikschaltkreisen an zumindest eine BUS-Leitung der BUS-Leitungen (111, 112, 121, 122, 131, 132; 211, 212, 221, 222, 231, 232) angeschlossen ist, wenn er mit der Aufnahmeeinrichtung verbunden ist,
wobei die BUS-Leitungen (111, 112, 121, 122, 131, 132; 211, 212, 221, 222, 231, 232) durch BUS-Verbindungsleitungen (141, 142, 143) miteinander verbindbar sind, wozu in jeder BUS-Verbindungsleitung (141, 142, 143) eine BUS-Schaltvorrichtung (141', 142', 143') vorgesehen ist,
wobei die elektrische Verbindungsstruktur (14; 24) so ausgebildet ist, dass die Mehrzahl von programmierbaren Logikschaltkreisen unabhängig miteinander verbindbar ist,
wobei zumindest ein Teil der Anschlusskontakte eines jeden programmierbaren Logikschaltkreises (11, 12, 13; 21, 22, 23) unabhängig belegbar ist,
wobei zumindest ein Teil der mit den programmierbaren Logikschaltkreisen (11, 12, 13; 21, 22, 23) verbundenen BUS-Leitungen (111, 112, 121, 122, 131, 132; 141, 142, 143; 211, 212, 221, 222, 231, 232) mittels BUS-Schaltvorrichtungen (111', 112'; 121', 122'; 131', 132'; 141', 142', 143') wahlweise miteinander elektrisch verbindbar ist, wobei jede BUS-Schaltvorrichtung eine Mehrzahl von Schaltern (S₁ ... Sₖ) aufweist,
dadurch charakterisiert, dass
jeder Kanal (1...k) einer ersten BUS-Leitung (111, 112, 121, 122, 131, 132; 141, 142, 143; 211, 212, 221, 222, 231, 232) nur mit einem zugeordneten Kanal (1...k) einer anderen BUS-Leitung (111, 112, 121, 122, 131, 132; 141, 142, 143; 211, 212, 221, 222, 231, 232) mittels jeweils eines Schalters aus der Mehrzahl der Schalter (S₁...Sₖ) zumindest einer der BUS-Schaltvorrichtungen (111', 112'; 121', 122'; 131', 132'; 141', 142', 143') elektrisch verbindbar ist.

2. Vorrichtung nach Anspruch 1,
**dadurch gekennzeichnet,**
**dass** eine Mehrzahl von Kanälen (1...k) einer BUS-Leitung (111, 112, 121, 122, 131, 132; 141, 142, 143; 211, 212, 221, 222, 231, 232) mit einer Mehrzahl von Kanälen (1...k) einer anderen BUS-Leitung (111, 112, 121, 122, 131, 132; 141, 142, 143; 211, 212, 221, 222, 231, 232) wahlweise elektrisch verbindbar ist, wobei jeder Kanal (1...k) der einen BUS-Leitung (111, 112, 121, 122, 131, 132; 141, 142, 143; 211, 212, 221, 222, 231, 232) mit dem Kanal (1...k) der anderen BUS-Leitung (111, 112, 121, 122, 131, 132; 141, 142, 143; 211, 212, 221, 222, 231, 232) elektrisch verbindbar ist, wobei einzelne Kanäle der Mehrzahl von Kanälen (1...k) unabhängig voneinander verbindbar sind.

3. Vorrichtung nach Anspruch 1,
**dadurch gekennzeichnet,**
**dass** sie zwischen zumindest einem Teil der programmierbaren Logikschaltkreise (11, 12, 13; 21, 22, 23) Verbindungs-BUS-Leitungen (15, 16, 17; 25, 26, 27) zur direkten Verbindung von zumindest einem Teil der programmierbaren Logikschaltkreise (11, 12, 13; 21, 22, 23) miteinander aufweist.

4. Vorrichtung nach Anspruch 1 mit mehreren Aufnahmeeinrichtungen,
**dadurch gekennzeichnet,**
**dass** die mehreren Aufnahmeeinrichtungen (1, 2; 3, 4; 5, 6) über Verbindungseinrichtungen (7A, 7B, 7C; 9A, 9B) miteinander verbindbar sind, wobei die Verbindungseinrichtungen (7A, 7B, 7C; 9A, 9B) schaltbare BUS-Leitungen aufweisen.

5. Vorrichtung nach Anspruch 4,
**dadurch gekennzeichnet,**
**dass** sie weiterhin Haupt-Verbindungseinrichtungen (7A, 7B, 7C) aufweist, die jeweils zwei Aufnahmeeinrichtungen (1, 2; 3, 4; 5, 6) miteinander verbinden, wobei die Haupt-Verbindungseinrichtungen (7A, 7B, 7C) Hauptverbindungseinrichtungs-BUS-Leitungen (711, 712, 721, 722, 731, 732) aufweisen, die einander zugeordnete BUS-Leitungen (111, 112, 121, 122, 131, 132; 211, 212, 221, 222, 231, 232) der beiden Aufnahmeeinrichtungen (1, 2) miteinander verbinden und wobei die Hauptverbindungseinrichtungs-BUS-Leitungen (711, 712, 721, 722, 731, 732) derart wahlweise miteinander elektrisch verbindbar sind, dass zumindest ein Kanal (1...k) einer Hauptverbindungseinrichtungs-BUS-Leitung (711, 712, 721, 722, 731, 732) mit einem Kanal (1...k) von zumindest einer anderen Hauptverbindungseinrichtungs-BUS-Leitung (711, 712, 721, 722, 731, 732) elektrisch verbindbar ist.

6. Vorrichtung nach Anspruch 5,
**dadurch gekennzeichnet,**
**dass** sie weiterhin Gruppen-Verbindungseinrichtungen (9A, 9B) aufweist, die jeweils zwei aus zwei mittels der Haupt-Verbindungseinrichtung (7A, 7B, 7C) verbundenen Aufnahmeeinrichtungen (1, 2; 3, 4; 5, 6) bestehende Aufnahmeeinrichtungspaare miteinander verbinden und wobei eine Gruppen-Verbindungseinrichtung (9A; 9B) Gruppenverbindungseinrichtungs-BUS-Leitungen (911, 912, 913, 914, 915, 916) aufweist, die mit den BUS-Leitungen der Aufnahmeeinrichtungspaare (1, 2; 3, 4; 5, 6) verbunden sind und wobei die Gruppenverbindungseinrichtungs-BUS-Leitungen (911, 912, 913, 914, 915, 916) jeweils derart schaltbar sind, dass jedem Kanal (1...k) einer jeden Gruppenverbindungseinrichtungs-BUS-Leitung (911, 912, 913, 914, 915, 916) ein Schalter einer Mehrzahl von Schaltern (S₁ ... Sₖ) zugeordnet ist und wobei jeder Schalter der Mehrzahl von Schaltern so ausgebildet ist, dass er unabhängig von den anderen Schaltern der Mehrzahl von Schaltern ein- und ausschaltbar ist.

7. Vorrichtung nach Anspruch 6,
**dadurch gekennzeichnet,**
**dass** die Aufnahmeeinrichtungen (1, 2, 3, 4, 5, 6), die Haupt-Verbindungseinrichtungen (7A, 7B, 7C) und die Gruppen-Verbindungseinrichtungen (9A, 9B) Leiterplatten (10, 20, 30, 40, 50, 60; 70A, 70B, 70C; 90A, 90B) aufweisen, die an ihrer Oberseite und an ihrer Unterseite jeweils mit einer Steckverbinderanordnung (V_{O}, V_{U}) versehen sind, die aus mehreren Steckverbindern besteht, welche in derselben Position auf den Leiterplatten (10, 20, 30, 40, 50, 60; 70A, 70B, 70C; 90A, 90B) angeordnet sind und wobei die nach außen führenden BUS-Leitungen der Leiterplatten (10, 20, 30, 40, 50, 60; 70A, 70B, 70C; 90A, 90B) sowohl mit oberen als auch mit entsprechenden unteren Steckverbindern der Steckverbinderanordnung (V_{O}, V_{U}) in gleicher Weise elektrisch verbunden sind.

8. Vorrichtung nach Anspruch 7,
**dadurch gekennzeichnet,**
**dass** die Leiterplatten (10, 20, 30, 40, 50, 60; 70A, 70B, 70C; 90A, 90B) übereinander angeordnet und mittels der Steckverbinderanordnungen (V_{O}, V_{U}) mechanisch und elektrisch miteinander verbunden sind,
wobei jeweils zwei Leiterplatten (10, 20; 30, 40; 50, 60) der Aufnahmeeinrichtungen (1, 2; 3, 4; 5, 6) mittels einer zwischen den beiden Leiterplatten der Aufnahmeeinrichtungen angeordneten Leiterplatte (70A, 70B, 70C) einer Haupt-Verbindungseinrichtung (7A, 7B, 7C) zu einem Aufnahmeeinrichtungspaar verbunden sind, um einen Aufnahmeeinrichtungs-Hauptverbindungsreinrichtungs-Leiterplattenstapel zu bilden,
wobei das Aufnahmeeinrichtungspaar eines von mehreren Aufnahmeeinrichtungspaaren ist, und
wobei die Aufnahmeeinrichtungspaare miteinander mittels der Leiterplatten (90A, 90B) der Gruppen-Verbindungseinrichtungen (9A, 9B) verbunden sind.

9. Vorrichtung nach Anspruch 8,
**dadurch gekennzeichnet,**
**dass** zwischen einigen der Steckverbinder der Steckverbinderanordnungen (V_{O}, V_{U}) ein Abstand (L) vorgesehen ist, der so dimensioniert ist, dass er das Durchströmen von Kühlluft zwischen den Steckverbindern durch den Leiterplattenstapel ermöglicht.

10. Vorrichtung nach Anspruch 1,
**dadurch gekennzeichnet,**
**dass** die Mehrzahl von programmierbaren Logikschaltkreisen FPGAs aufweist.

## Claims

1. A device for emulation of designs for integrated circuits, comprising:
at least one receiving device (1, 2, 3, 4, 5, 6) configured for receiving multiple programmable logic circuits (11, 12, 13; 21, 22, 23) having terminal contacts; and
an electrical connection structure (14; 24), which has BUS lines (111, 112, 121, 122, 131, 132; 211, 212, 221, 222, 231, 232), each of which includes multiple channels (1...k),
wherein each programmable logic circuit (11, 12, 13; 21, 22, 23) of the multiple programmable logic circuits when connected with the receiving device is connected to at least one BUS line of the BUS lines (111, 112, 121, 122, 131, 132; 211, 212, 221, 222, 231, 232),
wherein the BUS lines (111, 112, 121, 122, 131, 132; 211, 212, 221, 222, 231, 232) are connectable to one another by BUS connection lines (141, 142, 143) wherefore a BUS switching device (141', 142', 143') is provided in each BUS connection line (141, 142, 143),
wherein the electrical connection structure (14; 24) is configured so that the multiple programmable logic circuits are independently interconnectable with one another,
wherein at least a part of the terminal contacts of any programmable logic circuit (11, 12, 13; 21, 22, 23) is independently assignable,
wherein at least a part of the BUS lines (111, 112, 121, 122, 131, 132; 141, 142, 143; 211, 212, 221, 222, 231, 232) connected to the programmable logic circuits (11, 12, 13; 21, 22, 23) are alternately electrically connectable to one another using BUS switching devices (111', 112'; 121',122'; 131', 132'; 141', 142', 143'), wherein each BUS switching device comprises multiple switches (S₁...Sₖ),
**characterized**
**in that** each channel (1...k) of a first BUS line (111, 112, 121, 122, 131, 132; 141, 142, 143; 211, 212, 221, 222, 231, 232) is electrically connectable only to one assigned channel (1...k) of another BUS line (111, 112, 121, 122, 131, 132; 141, 142, 143; 211, 212, 221, 222, 231, 232) by a repective one of the multiple switches (S₁...Sₖ) of at least one of the BUS switching devices (111', 112'; 121',122'; 131', 132'; 141', 142', 143').

2. The device according to Claim 1,
**characterized**
**in that** the multiple channels (1...k) of a BUS line (111, 112, 121, 122, 131, 132; 211, 212, 221, 222, 231, 232; 141, 142, 143) are alternately electrically connectable to multiple channels (1...k) of another BUS line (111, 112, 121, 122, 131, 132; 141, 142, 143; 211, 212, 221, 222, 231, 232), each channel (1...k) of the one BUS line (111, 112, 121, 122, 131, 132; 141, 142, 143; 211, 212, 221, 222, 231, 232) being electrically connectable to the channel (1...k) of the other BUS line (111, 112, 121, 122, 131, 132; 141, 142, 143; 211, 212, 221, 222, 231, 232), individual channels of the multiple channels (1...k) being connectable independently of one another.

3. The device according to Claim 1,
**characterized by**
comprising connection BUS lines (15, 16, 17; 25, 26, 27) between at least a part of the programmable logic circuits (11, 12, 13; 21, 22, 23) for direct connection of at least a part of the programmable logic circuits (11, 12, 13; 21, 22, 23).

4. The device according to Claim 1, being one of multiple receiving devices **cha**
**racterized**
in that the multiple receiving devices (1, 2; 3, 4; 5, 6) are connectable to one another via connection devices (7A, 7B, 7C; 9A, 9B), the connection devices (7A, 7B, 7C; 9A, 9B) having switchable BUS lines.

5. The device according to Claim 4,
**characterized by**
further comprising main connection devices (7A, 7B, 7C), each of which connects two receiving devices (1, 2; 3, 4; 5, 6) to one another, the main connection devices (7A, 7B, 7C) having main connection device BUS lines (711, 712, 721, 722, 731, 732), which connect the BUS lines (111, 112, 121, 122, 131, 132; 211, 212, 221, 222, 231, 232) of the two receiving devices (1, 2) assigned to one another to one another and the main connection device BUS lines (711, 712, 721, 722, 731, 732) being alternately electrically connectable to one another in such a way that at least one channel (1...k) of a main connection device BUS line (711, 712, 721, 722, 731, 732) is electrically connectable to a channel (1...k) of at least one other main connection device BUS line (711, 712, 721, 722, 731, 732).

6. The device according to Claim 5,
**characterized by**
further comprising group connection devices (9A, 9B), each of which connects two receiving device pairs, including two receiving devices (1, 2; 3, 4; 5, 6), connected to one another using the main connection device (7A, 7B, 7C), to one another and a group connection device (9A; 9B) having group connection device BUS lines (911, 912, 913, 914, 915, 916), which are connected to the BUS lines of the receiving device pairs (1, 2; 3, 4; 5, 6), and the group connection device BUS lines (911, 912, 913, 914, 915, 916), each being switchable in such a way that each channel (1...k) of each group connection device BUS line (911, 912, 913, 914, 915, 916) is assigned one of a plurality of switches (S₁...Sₖ) and wherein each switch of the plurality of the switches is configured to be switched on and off independently of the other switches of the plurality of switches.

7. The device according to Claim 6,
**characterized**
**in that** the receiving devices (1, 2, 3, 4, 5, 6), the main connection devices (7A, 7B, 7C), and the group connection devices (9A, 9B) have circuit boards (10, 20, 30, 40, 50, 60; 70A, 70B, 70C; 90A, 90B), which are provided on their upper side and on their lower side with plug connector arrangements (V_{O}, V_{U}) which include multiple plug connectors situated in the same position on the circuit boards (10, 20, 30, 40, 50, 60; 70A, 70B, 70C; 90A, 90B) and the outward-leading BUS lines of the circuit boards (10, 20, 30, 40, 50, 60; 70A, 70B, 70C; 90A, 90B) are electrically connected to both upper and corresponding lower plug connectors of the plug connector arrangement (V_{O}, V_{U}) in the same way.

8. The device according to Claim 7,
**characterized**
**in that** the circuit boards (10, 20, 30, 40, 50, 60; 70A, 70B, 70C; 90A, 90B) are positioned one over another and are mechanically and electrically connected to one another using the plug connector arrangements (V_{O}, V_{U}),
wherein two circuit boards (10, 20, 30, 40, 50, 60) at a time of the receiving devices (1, 2; 3, 4; 5, 6) are connected into a receiving device pair using a circuit board (70A, 70B, 70C) of a main connection device (7A, 7B, 7C) positioned between the two circuit boards of the receiving devices, to form a receiving-device-main-connection-device circuit board stack,
wherein the receiving device pair is one of several receiving device pairs, and
wherein the receiving device pairs are connected to one another using the circuit boards (90A, 90B) of the group connection devices (9A, 9B).

9. The device according to Claim 8
**characterized**
**in that** a spacing (L) is provided between some of the plug connectors of the plug connector arrangements (V_{O}, V_{U}), the spacing being dimensioned to allow cool air to flow through the circuit board stack between the plug connectors.

10. The device of Claim 1,
**characterized**
**in that** the multiple programmable logic circuits comprise FPGAs.

## Revendications

1. Dispositif pour l'émulation de conceptions de circuits intégrés, comprenant
au moins un moyen de réception (1, 2, 3, 4, 5, 6) conçu pour recevoir plusieurs circuits logiques programmables (11, 12, 13 ; 21, 22, 23) ayant des contacts de raccordement et
une structure de connexion électrique (14 ; 24) qui présente des lignes de BUS (111, 112, 121, 122, 131, 132 ; 211, 212, 221, 222, 231, 232) qui comprennent chacune plusieurs canaux (1...k),
dans lequel chaque circuit logique programmable (11, 12, 13 ; 21, 22, 23) desdits plusieurs circuits logiques programmables est raccordé à au moins une ligne de BUS des lignes de BUS (111, 112, 121, 122, 131, 132 ; 211, 212, 221, 222, 231, 232) lorsqu'il est connecté au moyen de réception,
dans lequel les lignes de BUS (111, 112, 121, 122, 131, 132 ; 211, 212, 221, 222, 231, 232) peuvent être connectées entre elles par des lignes de connexion de BUS (141, 142, 143), un dispositif de commutation de BUS (141', 142', 143') étant prévu à cet effet dans chaque ligne de connexion de BUS (141, 142, 143),
dans lequel la structure de connexion électrique (14 ; 24) est conçue de telle sorte que lesdits plusieurs circuits logiques programmables peuvent être connectés entre eux indépendamment,
dans lequel au moins quelques-uns des contacts de raccordement de chaque circuit logique programmable (11, 12, 13 ; 21, 22, 23) peuvent être affectés indépendamment,
dans lequel au moins quelques-unes des lignes de BUS (111, 112, 121, 122, 131, 132 ; 141, 142, 143 ; 211, 212, 221, 222, 231, 232) connectées aux circuits logiques programmables (11, 12, 13 ; 21, 22, 23) peuvent être connectées électriquement entre elles de manière sélective au moyen de dispositifs de commutation de BUS (111', 112' ; 121', 122' ; 131', 132' ; 141', 142', 143'), chaque dispositif de commutation de BUS présentant plusieurs commutateurs (S₁...Sₖ),
**caractérisé en ce que**
chaque canal (1...k) d'une première ligne de BUS (111, 112, 121, 122, 131, 132 ; 141, 142, 143 ; 211, 212, 221, 222, 231, 232) peut être connecté électriquement à un seul canal associé (1...k) d'une autre ligne de BUS (111, 112, 121, 122, 131, 132 ; 141, 142, 143 ; 211, 212, 221, 222, 231, 232) au moyen d'un commutateur respectif desdits plusieurs commutateurs (S₁...Sₖ) d'au moins un des dispositifs de commutation de BUS (111', 112' ; 121', 122' ; 131', 132' ; 141', 142', 143').

2. Dispositif selon la revendication 1,
**caractérisé en ce**
**que** plusieurs canaux (1...k) d'une ligne de BUS (111, 112, 121, 122, 131, 132 ; 141, 142, 143 ; 211, 212, 221, 222, 231, 232) peuvent être connectés de manière sélective à plusieurs canaux (1...k) d'une autre ligne de BUS (111, 112, 121, 122, 131, 132; 141, 142, 143 ; 211, 212, 221, 222, 231, 232), chaque canal (1...k) d'une ligne de BUS (111, 112, 121, 122, 131, 132 ; 141, 142, 143 ; 211, 212, 221, 222, 231, 232) pouvant être connecté électriquement au canal (1...k) de l'autre ligne de BUS (111, 112, 121, 122, 131, 132 ; 141, 142, 143 ; 211, 212, 221, 222, 231, 232), des canaux individuels desdits plusieurs canaux (1...k) pouvant être connectés indépendamment les uns des autres.

3. Dispositif selon la revendication 1,
**caractérisé en ce**
**qu'**il présente des lignes de BUS de connexion (15, 16, 17 ; 25, 26, 27) entre au moins une partie des circuits logiques programmables (11, 12, 13 ; 21, 22, 23) pour la connexion directe d'au moins une partie des circuits logiques programmables (11, 12, 13 ; 21, 22, 23) entre eux.

4. Dispositif selon la revendication 1 comportant plusieurs moyens de réception,
**caractérisé en ce**
**que** lesdits plusieurs moyens de réception (1, 2; 3, 4 ; 5, 6) peuvent être connectés entre eux par des moyens de connexion (7A, 7B, 7C ; 9A, 9B),
les moyens de connexion (7A, 7B, 7C ; 9A, 9B) présentant des lignes de BUS commutables.

5. Dispositif selon la revendication 4,
**caractérisé en ce**
**qu'**il présente en outre des moyens de connexion principaux (7A, 7B, 7C) qui connectent chacun deux moyens de réception (1, 2 ; 3, 4; 5, 6) entre eux, les moyens de connexion principaux (7A, 7B, 7C) présentant des lignes de BUS de moyen de connexion principal (711, 712, 721, 722, 731, 732) qui connectent entre elles des lignes de BUS associées entre elles (111, 112, 121, 122, 131, 132 ; 211, 212, 221, 222, 231, 232) des deux moyens de réception (1, 2) et les lignes de BUS de moyen de connexion principal (711, 712, 721, 722, 722, 731, 732) pouvant être connectées électriquement entre elles de manière sélective, de sorte qu'au moins un canal (1...k) d'une ligne de BUS de moyen de connexion principal (711, 712, 721, 722, 731, 732) peut être connecté électriquement à un canal (1...k) d'au moins une autre ligne de BUS de moyen de connexion principal (711, 712, 721, 722, 731, 732).

6. Dispositif selon la revendication 5,
**caractérisé en ce**
**qu'**il présente en outre des moyens de connexion de groupe (9A, 9B) qui connectent chacun entre elles deux paires de moyens de réception constituées de deux moyens de réception (1, 2 ; 3, 4 ; 5, 6) connectés à l'aide du moyen de connexion principal (7A, 7B, 7C), dans lequel un moyen de connexion de groupe (9A ; 9B) présente des lignes de BUS de moyen de connexion de groupe (911, 912, 913, 914, 915, 916) qui sont connectées aux lignes de BUS des paires de moyens de réception (1, 2 ; 3, 4 ; 5, 6), dans lequel les lignes de BUS de moyen de connexion de groupe (911, 912, 913, 914, 915, 916) sont chacune commutables de sorte qu'à chaque canal (1...k) de chaque ligne de BUS de moyen de connexion de groupe (911, 912, 913, 914, 915, 916) est associé un commutateur de plusieurs commutateurs (S₁...Sₖ) et dans lequel chaque commutateur desdits plusieurs commutateurs est conçu pour pouvoir être activé et désactivé indépendamment des autres commutateurs desdits plusieurs commutateurs.

7. Dispositif selon la revendication 6,
**caractérisé en ce**
**que** les moyens de réception (1, 2, 3, 4, 5, 6), les moyens de connexion principaux (7A, 7B, 7C) et les moyens de connexion de groupe (9A, 9B) présentent des cartes de circuit imprimé (10, 20, 30, 40, 50, 60 ; 70A, 70B, 70C ; 90A, 90B) qui sont munies respectivement sur leur face supérieure et sur leur face inférieure d'un agencement de connecteurs (V_{O}, V_{U}) qui est constitué de plusieurs connecteurs qui sont disposés dans la même position sur les cartes de circuit imprimé (10, 20, 30, 40, 50, 60 ; 70A, 70B, 70C ; 90A, 90B) et les lignes de BUS des cartes de circuit imprimé (10, 20, 30, 40, 50, 60 ; 70A, 70B, 70C ; 90A, 90B) qui conduisent vers l'extérieur étant connectées électriquement de la même manière aussi bien à des connecteurs supérieurs qu'à des connecteurs inférieurs correspondants de l'agencement de connecteurs (V_{O}, V_{U}).

8. Dispositif selon la revendication 7,
**caractérisé en ce**
**que** les cartes de circuit imprimé (10, 20, 30, 40, 50, 60 ; 70A, 70B, 70C ; 90A, 90B) sont disposées l'une au-dessus de l'autre et connectées entre elles mécaniquement et électriquement au moyen des agencements de connecteurs (V_{O}, V_{U}),
chaque fois deux cartes de circuit imprimé (10, 20 ; 30, 40 ; 50, 60) des moyens de réception (1, 2 ; 3, 4 ; 5, 6) étant connectées en une paire de moyens de réception au moyen d'une carte de circuit imprimé (70A, 70B, 70C) d'un moyen de connexion principal (7A, 7B, 7C) disposée entre les deux cartes de circuit imprimé des moyens de réception, afin de former une pile de cartes de circuit imprimé de moyen de connexion principal,
la paire de moyens de réception étant l'une de plusieurs paires de moyens de réception et
les paires de moyens de réception étant connectées entre elles au moyen des cartes de circuit imprimé (90A, 90B) des moyens de connexion de groupe (9A, 9B).

9. Dispositif selon la revendication 8,
**caractérisé en ce**
**qu'**entre certains des connecteurs des agencements de connecteurs (V_{O}, V_{U}), il est prévu une distance (L) qui est dimensionnée de façon à permettre la circulation d'air de refroidissement entre les connecteurs à travers la pile de cartes de circuit imprimé.

10. Dispositif selon la revendication 1,
**caractérisé en ce**
**que** lesdits plusieurs circuits logiques programmables présentent des FPGA.
